# EUROPEAN PATENT APPLICATION

(11) **EP 4 692 987 A1**
(43) Date of publication of application: **11.02.2026**
(21) Application number: 25193338.8
(22) Date of filing: 01.08.2025
(51) Int. Cl.: G06F 1/20, G06F 1/26, H05K 7/20

(54) **COOLING CABINET**

(30) Priority: 08.08.2024 US 202463680676 P; 16.09.2024 US 202463694937 P; 10.06.2025 TW 114121617
(71) Applicant: Lite-On Technology Corporation, Neihu, Taipei 114 (TW)
(72) Inventor: TSENG, Pin-Chiao, 114 Taipei (TW); CHEN, Wen-Chi, 114 Taipei (TW); WANG, Ya-Ting, 114 Taiwan (TW)
(74) Representative: dompatent

(57) **Abstract**

A cooling cabinet includes a cabinet, a power shelf, a fan module and a distribution board. The power shelf is configured in the cabinet and is configured to convert alternating current into direct current. The fan module is disposed on the cabinet. The power distribution board is disposed on the cabinet and electrically connected to the fan module, and is configured to transmit the direct current to the fan module.

## Description

### BACKGROUND OF THE INVENTION

### Field of the Invention

The invention relates in general to a cooling cabinet for cooling a server.

### Description of the Related Art

In order to cool down electronic devices which generate heat when works, a water-cool type cooling cabinet is often used for achieving the desired cooling purpose. However, if the water-cool type cooling cabinet accidentally leaks water, it may result in current leakage which damages the electronic components of the cooling cabinet and causes electric shock to nearby personal. Therefore, it is necessary to propose a cooling cabinet that may reduce leakage damage.

### SUMMARY OF THE INVENTION

According to an embodiment of the present invention, a cooling cabinet is provided. The cooling cabinet includes a cabinet body, a power shelf, a fan module and a first power distribution board. The power shelf is disposed in the cabinet body and configured to convert a first alternating current (AC) into a first direct current (DC). The fan module is disposed in the cabinet body. The first power distribution board is disposed in the cabinet body and electrically connected to the fan module, and configured to transmit the first direct current to the fan module.

According to another embodiment of the present invention, a cooling cabinet is provided. The cooling cabinet includes a cabinet body, a power shelf, an AC pump and an inverter. The power shelf is disposed in the cabinet body and configured to convert a first alternating current into a first direct current. The AC pump is disposed in the cabinet body and configured to transmit a cooling liquid. The inverter is electrically connected to the power shelf with the AC pump, and configured to convert the first direct current into a second alternating current and provide the second alternating current to the AC pump for driving the AC pump.

The above and other aspects of the invention will become better understood with regard to the following detailed description of the preferred but non-limiting embodiment (s). The following description is made with reference to the accompanying drawings.

### BRIEF DESCRIPTION OF THE DRAWINGS

FIG. 1A shows a functional block diagram of a cooling cabinet according to an embodiment of the present disclosure;
FIGS. 1B and 1C show schematic diagrams of the cooling cabinet in FIG. 1A from different perspectives;
FIG. 2 shows a functional block diagram of a power shelf in FIG. 1;
FIGS. 3A and 3B show schematic diagrams of the cooling cabinet (a door cover is omitted) according to an embodiment of the present disclosure from different perspectives;
FIG. 4 shows a schematic diagram of a connection between a pump module assembly in FIG. 3A and a cooling module of the cooling cabinet; and
FIGS. 5A and 5B show schematic diagrams of the pump module assembly and the cooling module of the cooling cabinet of FIG. 3A from different perspectives.

### DETAILED DESCRIPTION OF THE INVENTION

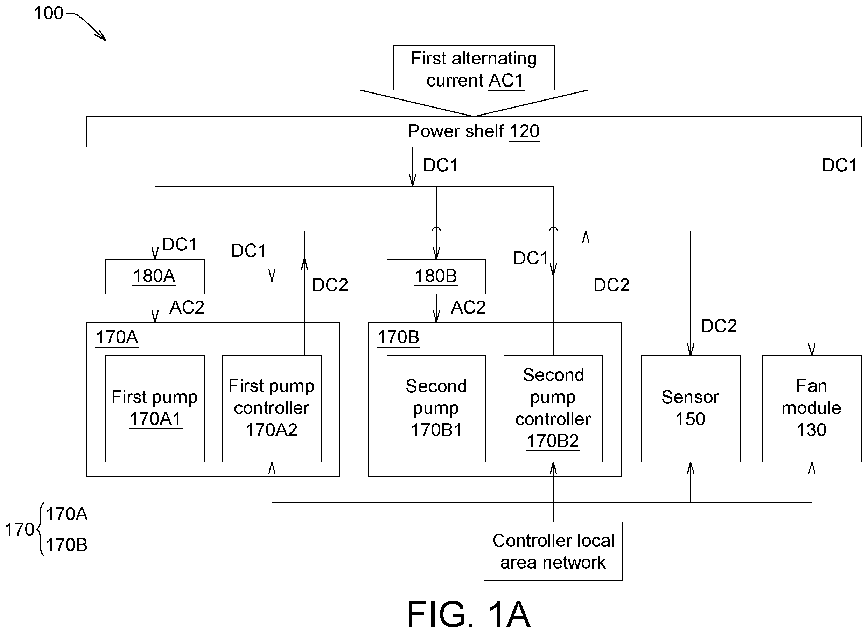

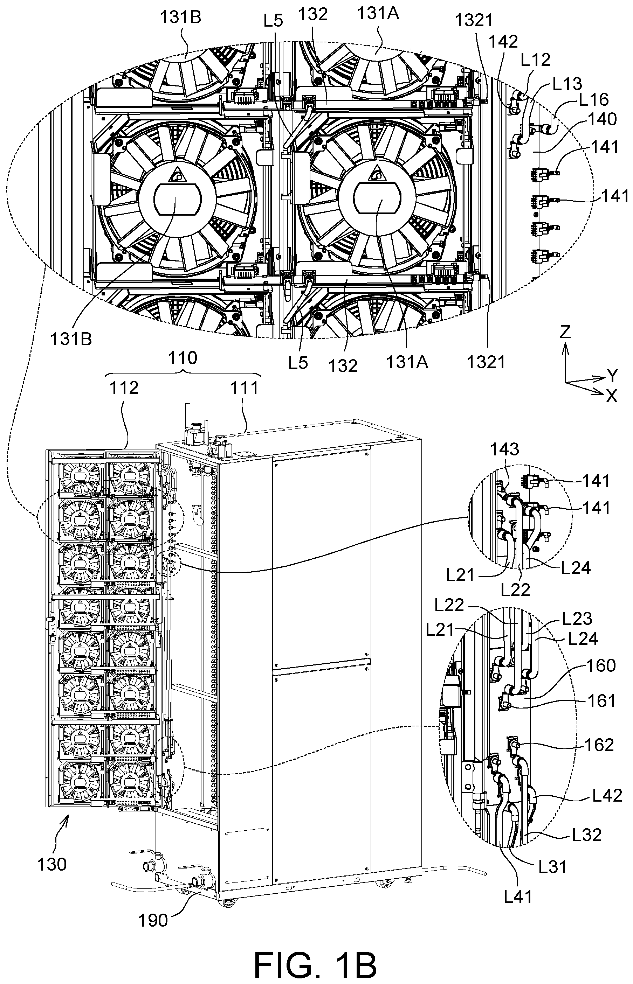

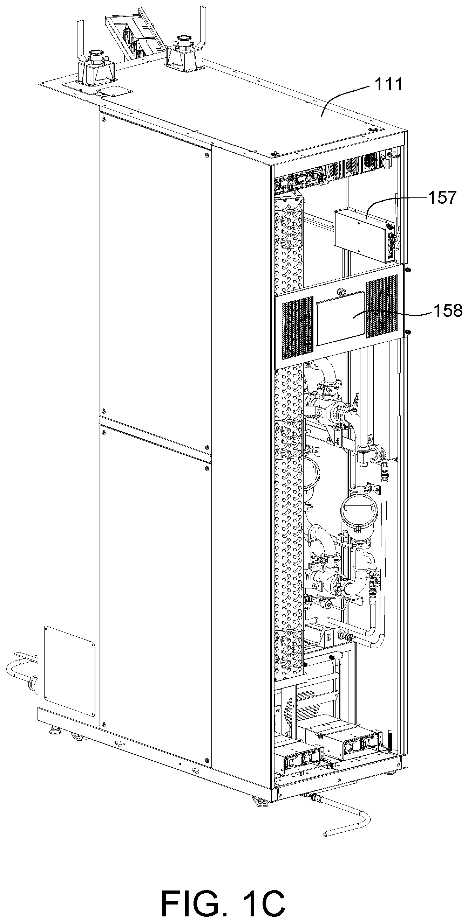

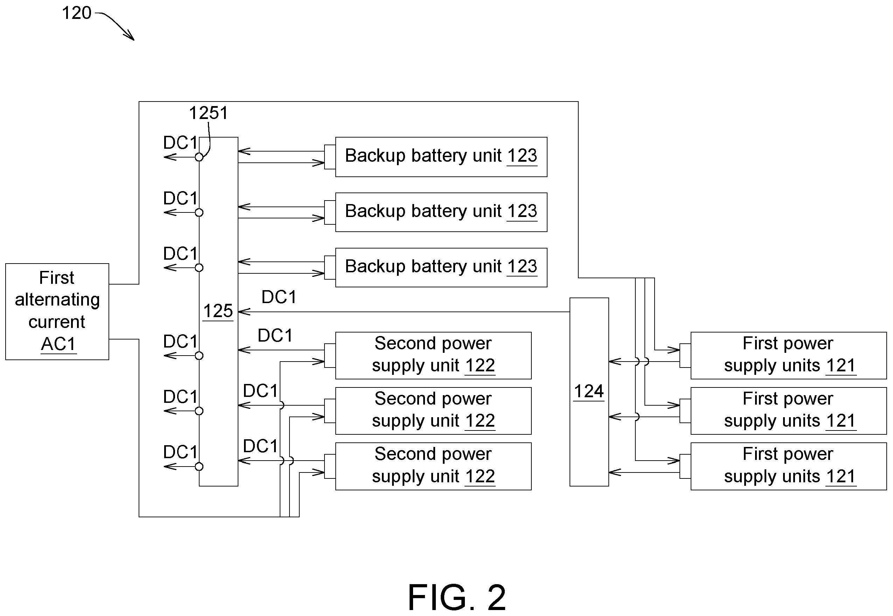

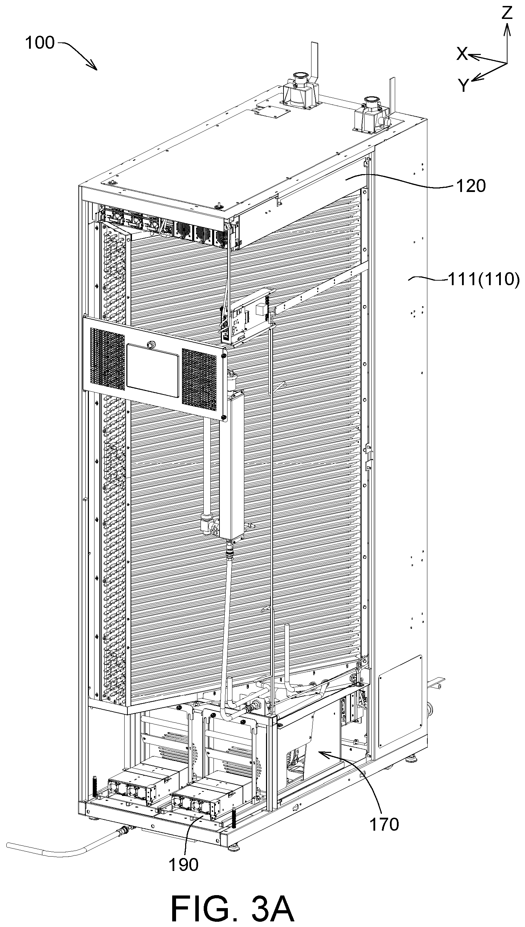

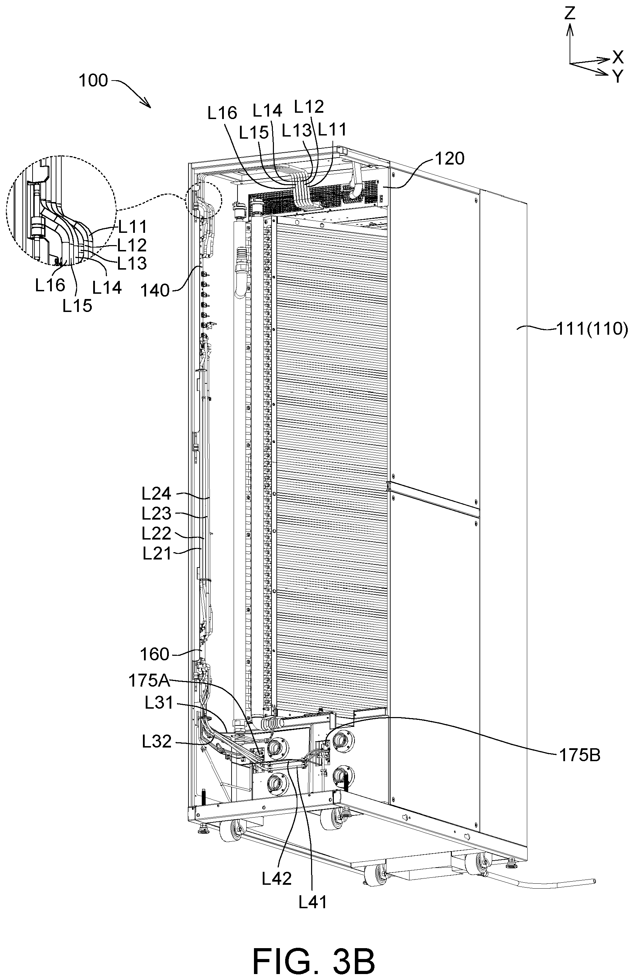

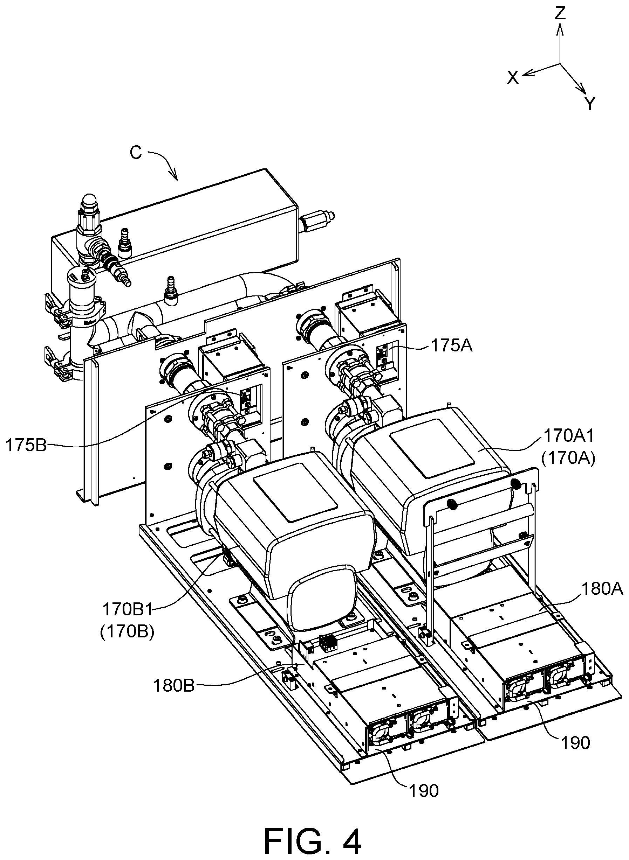

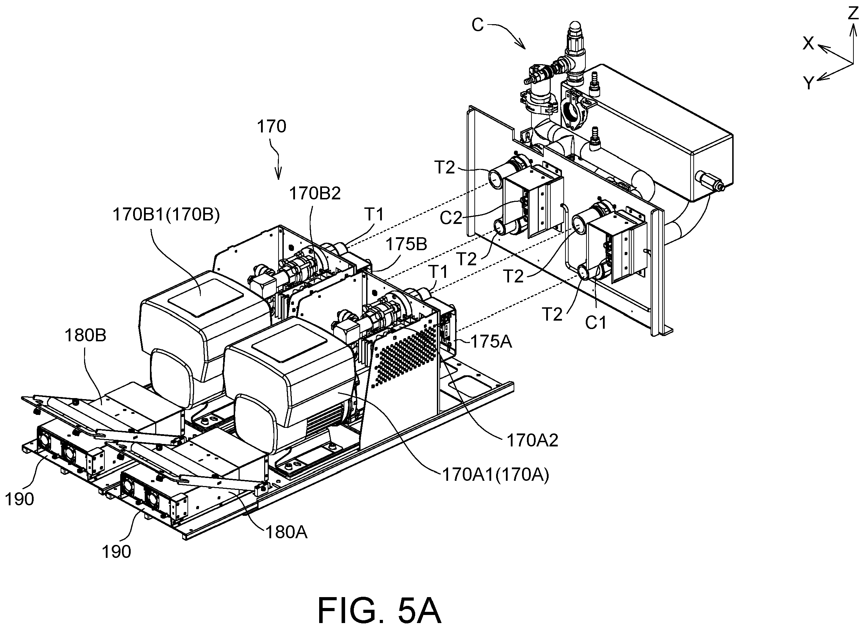

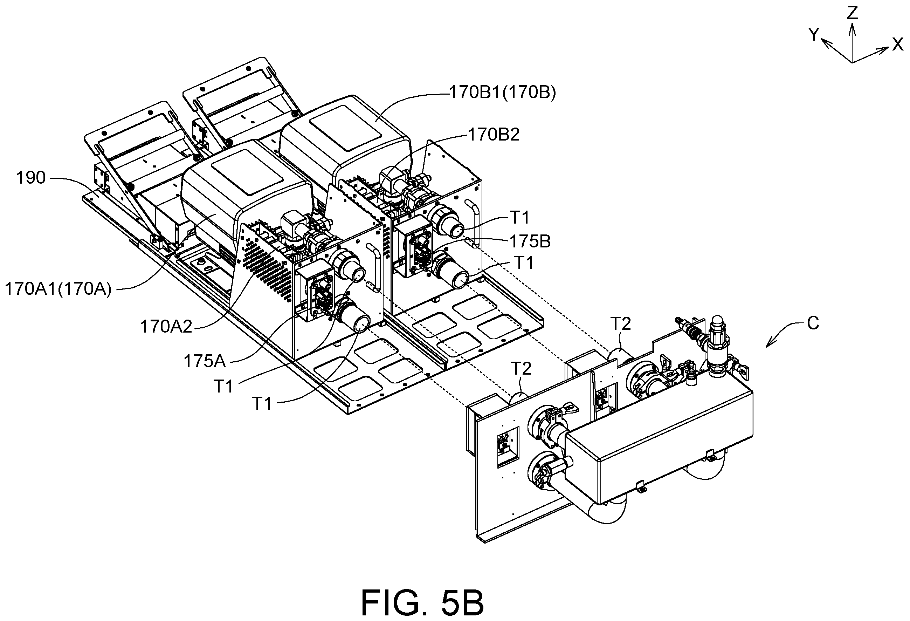

Referring to FIGS. 1 to 5B, FIG. 1A shows a functional block diagram of a cooling cabinet 100 according to an embodiment of the present disclosure. FIGS. 1B and 1C show schematic diagrams of the cooling cabinet 100 in FIG. 1A from different perspectives. FIG. 2 shows a functional block diagram of a power shelf 120 in FIG. 1. FIGS. 3A and 3B show schematic diagrams of the cooling cabinet 100 (a door cover 112 is omitted) according to an embodiment of the present disclosure from different perspectives. FIG. 4 shows a schematic diagram of a connection between a pump module assembly 170 in FIG. 3A and a cooling module of the cooling cabinet 100. FIGS. 5A and 5B show schematic diagrams of the pump module assembly 170 and the cooling module of the cooling cabinet 100 of FIG. 3A from different perspectives.

The cooling cabinet 100 is configured to cool an electronic device (not shown), for example, a server, such as a cloud server, an artificial intelligence (AI) server, a big data server, a data center or other types of electronic devices with high-power consumption or high-heat generation.

As shown in FIGS. 1A, 1B and 3B, the cooling cabinet 100 includes a cabinet body 110, the power shelf 120, a fan module 130, a first power distribution board 140, at least one sensor 150, a second power distribution board 160, a pump module assembly 170 (for example, including a first pump module 170A and a second pump module 170B), a first connector 175A, a second connector 175B, a first inverter 180A, a second inverter 180B, at least one sliding plate 190, a plurality of first power lines L11 to L16, a plurality of second power lines L21 to L24, a plurality of third power lines L31 to L32 and a plurality of fourth power lines L41 to L42.

As shown in FIGS. 1A and 1B, the power shelf 120 is disposed in the cabinet body 110 and is configured to convert a first alternating current AC1 into a first direct current DC1. The fan module 130 is disposed on the cabinet body 110. The first power distribution board 140 is disposed on the cabinet body 110, electrically connected to the fan module 130 and configured to transmit the first direct current DC1 to the fan module 130. In the present embodiment, the cooling cabinet 100 converts alternating current into the first direct current. Since the voltage of the first direct current is significantly lower than the voltage of the alternating current, the damage caused by the current leakage to the cooling cabinet and/or the surrounding objects (e.g., personnel) may be reduced.

In an embodiment, the first alternating current AC1 is, for example, a three-phase alternating current, and its voltage ranges, for example, between 380 volts and 480 volts, and the voltage of the first direct current DC1 is, for example, 48 volts.

As shown in FIGS. 1A and 1B, the cabinet body 110 includes a chassis 111 and the door cover 112. The door cover 112 is pivotally connected to the chassis 111. The fan module 130 is disposed on the door cover 112, for example, secured to the door cover 112 by screws. The power shelf 120, the first power distribution board 140, the sensor 150, the second power distribution board 160, the pump module assembly 170 and the sliding plate 190 are disposed inside the chassis 111, wherein the first power distribution board 140 and the second power distribution board 160 are, for example, screwed to the chassis 111 by at least one screw. In addition to providing wire management functionality, the second power distribution board 160 may also reduce the increase in resistance caused by excessively long wires.

As shown in FIG. 2, the power shelf 120 includes at least one first power supply unit (PSU) 121, at least one second power supply unit 122, at least one backup battery unit (BBU) 123, a first bus bar 124 and a second bus bar 125. The first alternating current AC1 may be transmitted to the first power supply unit 121, and the first power supply unit 121 is configured to convert the first alternating current AC1 into the first direct current DC1. A plurality of the first power supply units 121 are electrically connected to the first bus bar 124, and output the first direct current DC1 through the first bus bar 124. In addition, the first alternating current AC1 may be transmitted to the second power supply unit 122, and the second power supply unit 122 is configured to convert the first alternating current AC1 into the first direct current DC1. The second power supply unit 122 is electrically connected to the second bus bar 125, and outputs the first direct current DC1 through the second bus bar 125. The first direct current DC1 may provide the power required for the cooling cabinet 100 to perform heat exchange. The backup battery unit 123 is electrically connected to the second bus bar 125. When the first alternating current AC1 cannot be normally supplied to the power supply unit, an internal power of the backup battery unit 123 may output a direct current of the same potential (i.e. the potential of the first direct current DC1) to the first power distribution board 140 through a discharge circuit (not shown), until the first alternating current AC1 is restored. In addition, the second bus bar 125 is electrically connected to the first bus bar 124, and the second bus bar 125 includes N1 output ports 1251, and the first direct current DC1 may be output through N1 output ports 1251. N1 is, for example, a positive integer equal to or greater than 1. In the present embodiment, N1 is exemplified as six, but this is not intended to limit the scope of the present invention.

In an embodiment, the number of first power supply units 121 is, for example, three; the number of second power supply units 122 is, for example, three; and the number of battery backup units 123 is, for example, three. However, they are not intended to limit the scope of the present invention.

As shown in FIG. 1B, the fan module 130 includes N2 first fans 131A, N2 second fans 131B and N2 circuit boards 132, wherein N2 is, for example, a positive integer equal to or greater than 1. In the present embodiment, N2 is exemplified as eight, but this is not intended to limit the scope of the present embodiment. Each circuit board 132 is electrically connected to the first fan 131A and the second fan 131B in the same row (for example, along the Y-axis). Each circuit board 132 is electrically connected to the first power distribution board 140. The first direct current DC1 may be provided to each circuit board 132 through the first power distribution board 140, and then provided to the fans 131A and 131B through the circuit board 132. In addition, two adjacent fans 131A and 131B (for example, along the Z-axis) may be connected through a connecting wire L5. A plurality of the connecting wire L5 may connect all fans in the same column (for example, along the Z-axis) in series to control the rotation speed of the fan 131A and the rotation speed of the fan 131B. In addition, the first direct current DC1 may also be provided to the inverter (180A and 180B) through the first power distribution board 140.

As shown in FIGS. 1B and 2, the first power distribution board 140 includes N1 first connection ports 141, N2 second connection ports 142, and N3 third connection ports 143. The first power lines L11 to L16 (the first power lines L11 to L16 are shown in FIG. 3B) may connect the N1 output ports 1251 of the second bus bar 125 to the N1 first connection ports 141 of the first power distribution board 140. As a result, the first direct current DC1 from the power shelf 120 may be transmitted to the N1 first connection ports 141 through the first power lines L11 to L16. In addition, the N2 second connection ports 142 may be respectively connected to the N2 connection ports 1321 of the N2 circuit boards 132 through N2 power lines (not shown). The first direct current DC1 may be supplied to the connection port 1321 of the corresponding circuit board 132 and to the first fan 131A and the second fan 131B connected thereto through each second connection port 142 to drive the fan to operate. In order to avoid danger caused by the liquid leakage, a cover (not shown) may also be disposed above the first power distribution board 140 (for example, along X-axis) to cover the entire first power distribution board 140 in the Z-axis. The cover has a notch to expose the first connection port 141 so that the first connection port 141 may be connected to the connection port 1321 through at least one power line (not shown).

As shown in FIGS. 1A and 1B, the sensor 150 is, for example, a temperature sensor, a pressure sensor, a flow sensor, a liquid-level sensor, a liquid leakage sensor, etc. The sensor 150 may be disposed on the cabinet body 110. The sensor 150 may be driven by direct current. As shown in FIG. 1A, the first pump controller 170A2 and the second pump controller 170B2 are electrically connected to the power shelf 120 and the sensor 150. The first pump controller 170A2 and the second pump controller 170B2 are configured to convert the first direct current DC1 into a second direct current DC2 of different voltage, wherein the voltage of the second direct current DC2 may be lower than the voltage of the first direct current DC1. For example, the pump controller may convert the first direct current DC1 of 48 volts into the second direct current DC2 of 24 volts for the operation of the sensor 150.

As shown in FIGS. 1A and 1C, the controller 157 may be disposed on the chassis 111 and electrically connected to the sensor 150, the power shelf 120, the fan module 130, the first pump module 170A and the second pump module 170B, etc., to control the operation of these components and/or receive signals from these components. In addition, the controller 157 may control the components connected thereto, such as the sensor 150, the power shelf 120, the fan module 130, the first pump module 170A and the second pump module 170B, etc., through the local area network. The controller 157 may receive the first direct current DC1 from the power shelf 120 and use the first direct current DC1 as a driving power source. In addition, the cooling cabinet 100 further includes a human-machine interface 158 which is disposed on the chassis 111. The controller 157 receives the first direct current DC1 from the power shelf 120 and provides the first direct current DC1 to the human-machine interface 158.

As shown in FIGS. 1A, 1B and 3B, the second power distribution board 160 is electrically connected to the first power distribution board 140 and is configured to transmit the direct current to the pump controller. For example, the first direct current DC1 is transmitted to the first pump controller 170A2 of the first pump module 170A and the second pump controller 170BA2 of the second pump module 170B through the first power distribution board 140 and the second power distribution board 160. The second power distribution board 160 includes N4 fourth connection ports 161 and N5 fifth connection ports 162. The second power lines L21 to L24 may connect the first power distribution board 140 and the second power distribution board 160. For example, the second power lines L21 to L24 may connect the N3 third connection ports 143 of the first power distribution board 140 with the N4 fourth connection ports 161 of the second power distribution board 160. In the present embodiment, N3, N4 and N5 are, for example, positive integers equal to or greater than 1. In the present embodiment, the values of N3, N4, and N5 are illustrated using the example of four; however, this is not intended to limit the scope of the present invention.

As shown in FIGS. 1B and 3B, the third power lines L31 to L32 connect the second power distribution board 160 with the first pump module 170A (the first pump module 170A is shown in FIG. 1A), and the fourth power lines L41 to L42 connect the second power distribution board 160 with the second pump module 170B (the second pump module 170B is shown in FIG. 1A) to provide the first direct current DC1 to the pump module. Furthermore, the third power lines L31 to L32 are connected to some of the N4 fifth connection ports 162 of the second power distribution board 160 with the first pump module 170A, and the fourth power lines L41 to L42 are connected to some of the N4 fifth connection ports 162 of the second power distribution board 160 with the second pump module 170B. However, the pump of the pump module does not directly use direct current to operate, and it will be explained later.

In summary, the first direct current DC1 may be transmitted to the fan module 130, the controller 157, the pump controllers (170A2 and 170B2) and/or the inverters (180A and 180B) through the first power distribution board 140 and/or the second power distribution board 160.

As shown in FIGS. 1A and 3B, the first pump module 170A includes a first pump 170A1 and the aforementioned first pump controller 170A2. The first pump controller 170A2 is electrically connected to the first pump 170A1 to control the operation of the first pump 170A1. The second pump module 170B includes a second pump 170B1 and the aforementioned second pump controller 170B2. The second pump controller 170B2 is electrically connected to the second pump 170B1 to control the operation of the second pump 170B1.

As shown in FIGS. 3B and 4, the third power lines L31 to L32 may be connected to the first connector 175A to be electrically connected to the first inverter 180A through the first connector 175A. The fourth power lines L41 to L42 may be connected to the second connector 175B to be electrically connected to the second inverter 180B through the first connector 175A.

As shown in FIGS. 4 and 5, the connectors (the first connector 175A and the second connector 175B) may be electrically connected to the inverters (the first inverter 180A and the second inverter 180B). For example, although not shown, the first connecting wire (not shown) may connect the first connector 175A with the first inverter 180A to transmit the first direct current DC1 to the first inverter 180A. The first inverter 180A is electrically connected to the first pump 170A1. The first inverter 180A is configured to convert the first direct current DC1 into the second alternating current AC2. Although not shown, the second connecting wire (not shown) may connect the second connector 175B with the second inverter 180B to transmit the first direct current DC1 to the second inverter 180B. The second inverter 180B is electrically connected to the second pump 170B1. The second inverter 180B is configured to convert the first direct current DC1 into the second alternating current AC2. In an embodiment, the second alternating current AC2 is less than the first alternating current AC1, for example, 220 volts, and its power is, for example, 1.5 kilowatts (kW). The first pump 170A1 and the second pump 170B1 may be selected as pumps driven by alternating current (e.g., AC pumps), which allow the pumps to operate with greater horsepower compared to direct current, thereby increasing the flow rate or volume of the cooling liquid and improving the cooling efficiency of the electronic device.

As shown in FIGS. 4 and 5, the inverter (the first inverter 180A and the second inverter 180B) are electrically connected to the pumps (the first pump 170A1 and the second pump 170B1). For example, although not shown, a third connecting wire (not shown) may connect the first inverter 180A and the first pump 170A1 (the first pump 170A1 is shown in FIG. 1A) to transmit the second alternating current AC2 to the first pump 170A1 to drive the first pump 170A1 to operate. Although not shown, a fourth connecting wire (not shown) may connect the second inverter 180B with the second pump 170B1 (the second pump 170B1 is shown in FIG. 1A) to transmit the second alternating current AC2 to the second pump 170B1 to drive the second pump 170B1 to operate. In other words, the first pump 170A1 and the second pump 170B1 of the embodiment of the present invention are operated by AC. Compared with the lower efficiency of the DC pump, the cooling cabinet of the embodiment of the present invention adopts the AC pump with higher efficiency.

As shown in FIGS. 4 and 5A to 5B, the first pump module 170A and the first inverter 180A are disposed on one of the sliding plates 190. The sliding plate 190 is slidably disposed relative to the chassis 111, for example, it may slide relatively along the Y axis. Thus, by moving the sliding plate 190, the first pump module 170A and the first inverter 180A located thereon may be moved. Similarly, the second pump module 170B and the second inverter 180B are disposed on one of the sliding plates 190. The sliding plate 190 is slidably disposed relative to the chassis 111. Thus, by moving the sliding plate 190, the second pump module 170B and the second inverter 180B located thereon may be moved.

As shown in FIGS. 4 and 5A to 5B, the first pump 170A1 of the first pump module 170A and the second pump 170B1 of the second pump module 170B may be connected to at least one quick-release connector T2 of the cooling module C by using at least one quick-release connector T1. The cooling module C is, for example, a liquid-cooled radiator, so that the pump may drive the cooling liquid (not shown) to the coolant pipeline of the cooling module C for cooling. Each quick-release connector T1 of the first pump module 170A is, for example, one of a male end or a female end, and the quick-release connector T2 of the cooling module C connected thereto is, for example, the other of the male end or the female end. In addition, one of the two quick-release connectors T1 connected to the first pump module 170A is, for example, a male end, and the other of the two quick-release connectors T1 connected to the first pump module 170A is, for example, a female end. The quick-release connector T1 connected to the second pump module 170B has structural features similar to or same as those of the quick-release connector T1 connected to the first pump module 170A, and it will not be repeated here.

As shown in FIGS. 5A and 5B, when the sliding plate 190 slides in a direction away from the cooling module C, the pump and the cooling module C may be disconnected, and the electrical connectors (e.g., the first connector 175A and the second connector 175B) and the electrical connectors C1 and C2 of the cooling module C may be disconnected at the same time. The first pump 170A1 and the second pump 170B1 are plugged in and out using quick-release connector (or quick connectors). Since the wires connecting the electrical connectors and the inverters (e.g., the first inverter 180A and the second inverter 180B) in the embodiment of the present invention are low-voltage (e.g., <60V), there is relatively less safety concern even if leakage occurs.

In summary, the present disclosure provides a cooling cabinet for cooling a server. The power shelf of the cooling cabinet may convert the first AC into the DC which is used as the power supply for most components in the cooling cabinet. Since the voltage of direct current is lower than that of alternating current, the damage caused by leakage to the cooling cabinet and/or surrounding objects (e.g., personnel) may be reduced. In an embodiment, except for the pump (e.g., AC pump), other electronic components all use DC to operate (e.g., the power supply unit and the pump in the cooling cabinet use AC, or only the power supply unit and the pump in the cooling cabinet use AC). However, in another embodiment, the pump may also be a DC pump.

While the invention has been described by way of example and in terms of the preferred embodiment (s), it is to be understood that the invention is not limited thereto. Based on the technical features embodiments of the present invention, a person ordinarily skilled in the art will be able to make various modifications and similar arrangements and procedures without breaching the spirit and scope of protection of the invention. Therefore, the scope of protection of the present invention should be accorded with what is defined in the appended claims.

## Claims

1. A cooling cabinet (100), **characterized in that** the cooling cabinet (100) comprises:
a cabinet body (110);
a power shelf (120), disposed in the cabinet body (110) and configured to convert a first alternating current (A1) into a first direct current (DC1);
an AC pump (170A1, 170B1), disposed in the cabinet body (110) and configured to transmit a cooling liquid; and
an inverter (180A, 180B), electrically connected to the power shelf (120) with the AC pump (170A1, 170B1), and configured to convert the first direct current (DC1) into a second alternating current (AC2) and provide the second alternating current (AC2) to the AC pump (170A1, 170B1) for driving the AC pump (170A1, 170B1).

2. The cooling cabinet (100) as claimed in claim 1, **characterized in that** the cooling cabinet (100) further comprises a first power distribution board (140) disposed on the cabinet body (110), electrically connected to the power shelf (120), and configured to transmit the first direct current (DC1) to the inverter (180A, 180B).

3. The cooling cabinet (100) as claimed in claim 1, **characterized in that** the cooling cabinet (100) further comprises a fan module (130) disposed on the cabinet body (110), wherein the fan module (130) is electrically connected to a first power distribution board (140), and the fan module (130) is driven by receiving the first direct current (DC1) input by the first power distribution board (140).

4. The cooling cabinet (100) as claimed in claim 1, **characterized in that** the cooling cabinet (100) further comprises a pump controller (170A2, 170B2) and a sensor (150), wherein the pump controller (170A2, 170B2) electrically connects the power shelf (120) with the sensor (150), is configured to convert the first direct current (DC1) into a second direct current (DC2) of a different voltage and provides the second direct current (DC2) to the sensor (150).

5. The cooling cabinet (100) as claimed in claim 1, **characterized in that** the cooling cabinet (100) further comprises a controller (157), which is disposed in the cabinet body (110), electrically connected to the power shelf (120) and configured to receive the first direct current (DC1).

6. The cooling cabinet (100) as claimed in claim 1, **characterized in that** the cooling cabinet (100) further comprises a second power distribution board (160) which is disposed in the cabinet body (110), and electrically connected to a first power distribution board (140) for transmitting the first direct current (DC1) to the AC pump (170A1, 170B1).
